Europäisches Patentamt

European Patent Office

Office européen des brevets

(11) Veröffentlichungsnummer: **0 451 490 A2**

## (12) EUROPÄISCHE PATENTANMELDUNG

(21) Anmeldenummer: **91103090.6**

(22) Anmeldetag: **01.03.91**

(51) Int. Cl.5: **B23K 3/047**

(30) Priorität: **12.04.90 CH 1268/90**

(43) Veröffentlichungstag der Anmeldung:
**16.10.91 Patentblatt 91/42**

(84) Benannte Vertragsstaaten:
**CH FR GB IT LI NL**

(71) Anmelder: **ROSSELL ELECTRONIQUE S.A.**
**Fährhütte**
**CH-9477 Trübbach(CH)**

(72) Erfinder: **Zeltner, Viktor**
**Joachimsbühl**
**CH-9475 Sevelen(CH)**

(74) Vertreter: **Troesch Scheidegger Werner AG**
**Patentanwälte, Siewerdtstrasse 95, Postfach**
**CH-8050 Zürich(CH)**

(54) **Thermode für einen elektrisch beheizten Lötkopf.**

(57) Die Thermode (7) für einen elektrisch beheizten Lötkopf einer Lotmaschine weist einen Träger (8) und ein zum Aufliegen auf dem Lötgut vorgesehenes Heizorgan (11) auf, welches federelastisch ausgebildet ist, um sich der Form und Lage der Lötstellen anzupassen. Dieses Organ (11) ist draht- oder streifenförmig ausgebildet. Zwischen dem Träger (8) und den Organ (11) ist eine gummielastische Stützmasse (9) angeordnet. Das Heizorgan (11) ist in der Stützmasse (9) geführt, z.B. in einer Nut. Diese Thermode ist derart aufgebaut, dass sie sich der zu lötenden Unterlage anzupassen vermag und damit optimale Lötbedingungen schafft.

Fig. 2

EP 0 451 490 A2

Die vorliegende Erfindung betrifft eine Thermode für einen elektrisch beheizten Lötkopf einer Lötmaschine, insbesondere eines Lötautomaten.

Die bekannten Thermoden, wie sie beispielsweise in der US-PS 4 912 743 beschrieben sind, weisen formsteife Lötflächen auf, was den Nachteil mit sich bringt, dass sie zum qualitätssicheren Löten den Lötflächen der Thermode genau entsprechende Flächen des Lötgutes aufweisen müssen. Da diese Thermoden normalerweise ebene Lötflächen haben, können sie sich an unebene Unterlagen, insbesondere gebogene Unterlagen, nicht anpassen, so dass der gravierende Nachteil, insbesondere bei automatischem Lötablauf, entsteht, dass die Qualität der einzelnen Lötstellen unterschiedlich ist und gegebenenfalls gewisse Stellen ungelötet bleiben. Um eine qualitätsmässig gute Lötung zu erreichen, ist es nötig, dass die ganze zu lötende Fläche gleichmässig mit Wärme beaufschlagt wird, was bezüglich Oberfläche eine gleichmässige Kontaktnahme der Thermode mit dem zu lötenden Gut verlangt.

Die vorliegende Erfindung bezweckt die Schaffung einer Thermode, welche derart aufgebaut ist, dass sie sich der zu lötenden Unterlage anzupassen vermag und damit optimale Lötbedingungen schafft.

Eine derartige Thermode zeichnet sich durch einen der Ansprüche aus.

Die Erfindung wird anschliessend anhand von Fig. erläutert.

Es zeigen:

Fig. 1     eine bekannte Thermode mit ebener Lötfläche, unmittelbar vor dem Löten eines Bauteils auf eine gebogene Leiterplatte,

Fig. 2     eine Thermode gemäss der Erfindung,

Fig. 3     die Thermode gemäss Fig. 2 im Löteinsatz beim Löten eines Bauteils auf eine gekrümmte Leiterplatte,

Fig. 4     einen Querschnitt durch eine Thermode analog den Fig. 2 und 3, mit formschlüssiger Befestigung der Stützmasse,

Fig. 5     einen Schnitt analog Fig. 4, mit kraftschlüssiger Befestigung der Stützmasse am Träger.

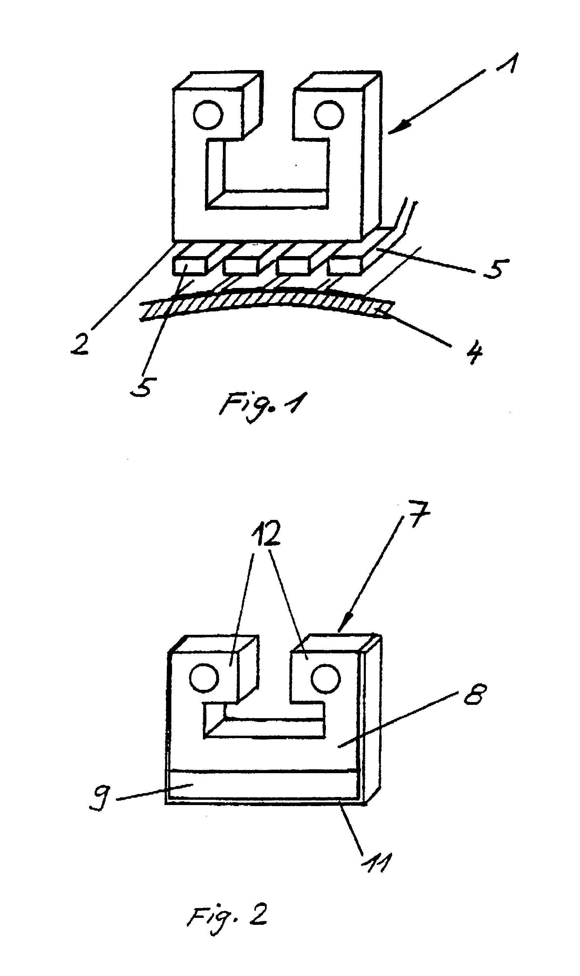

Die bekannten Thermoden 1 weisen normalerweise eine ebene Lötkontaktfläche 2 auf, so dass, wenn eine Leiterplatte 4 mit Bauteilanschlüssen 5 nicht ein ebenes, sondern, wie Fig. 1 zeigt, ein gebogenes Gebilde darstellt, die Lötung ungleichmässig erfolgt, da die Wärmeübertragung in den mittleren Bauteilanschlüssen 5 grösser ist als an den aussenliegenden Anschlüssen. Damit wird die Qualität der Lötung ungleichmässig.

Diesem Uebelstand kann dadurch abgeholfen werden, dass im Sinne der Fig. 2, welche eine Thermode 7 mit einem Trägerteil 8 zeigt, am Trägerteil 8 eine aus gummielastischem Material bestehende Stützmasse 9, beispielsweise aus Teflon, Silikon, Gummi, Leder o. dgl. anzuordnen.

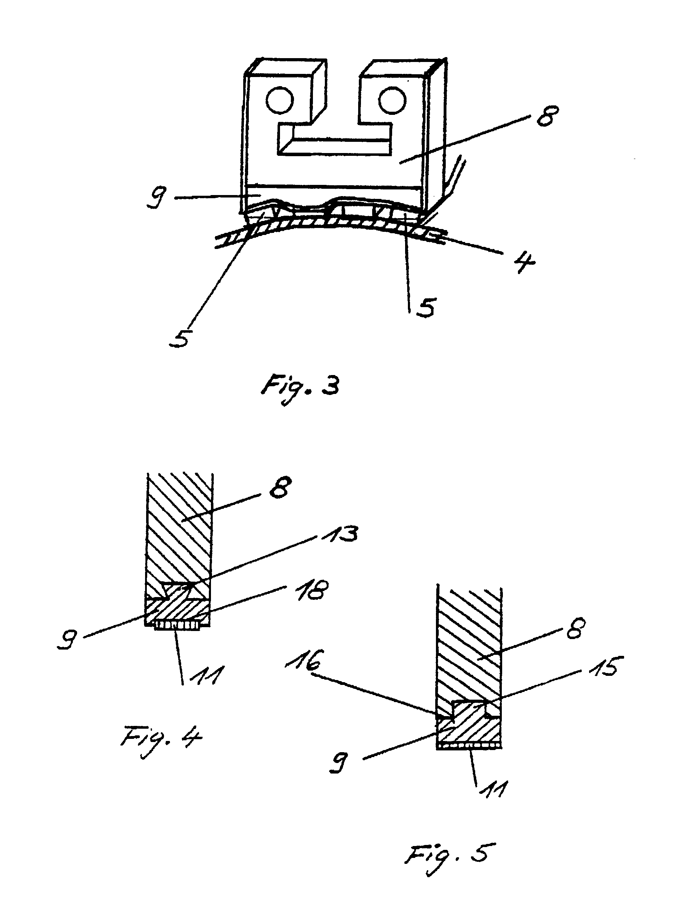

Ein Heizorgan 11 in Form eines Wolfram- oder Stahldrahtes bzw. -streifens ist mit den Enden mit den Polen 12 der Thermode 7 verbunden und umfasst, wie die Fig. 2 und 3 zeigen, den Trägerteil 8 und die Stützmasse 9. Das Heizorgan 11 liegt an der freien Fläche der Stützmasse 9 auf und kann sich mit dieser der Form der Leiterplatte 4 und der Bauteilanschlüsse 5 anpassen, auch wenn diese Bauteilanschlüsse 5 ungleich hoch sind, wie dies in Fig. 3 dargestellt ist. Zu diesem Zwecke ist es vorteilhaft, die Heizorgane 11 selbst federnd auszubilden. Dies kann beispielsweise durch schraubenförmige Windung des Drahtes sein oder dadurch, dass die an die Pole 12 grenzenden Draht- oder Streifenenden am einen oder beiden Polen über Zugfedern befestigt werden.

Wie in Fig. 4 dargestellt, kann die Stützmasse 9 formschlüssig, beispielsweise über eine Schwalbenschwanzführung 13, mit dem Trägerteil 8 verbunden sein, während das Heizorgan 11 z.B. in einer Nut 18 der Stützmasse 9 von dieser gehalten wird.

Es ist aber auch möglich, die Verbindung zwischen dem Trägerteil 8 und der Stützmasse 9 kraftschlüssig über eine Nut 15 vorzusehen und die beiden Teile über eine Klebeschicht 16 zu verbinden.

Diese neue, in den Fig. 2 bis 5 dargestellte Thermode erlaubt den Einsatz der Stempellötmethode auch für Automaten mit hohen Produktionsgeschwindigkeiten. Da bei derartigen Automaten die Lötbedingungen bezüglich Beschaffenheit der Leiterplatten und der Bauteilanschlüsse nicht mit Sicherheit optimal eingehalten werden können, ist eine Anwendung des Stempellötverfahrens mit den bisher bekannten starren Lötflächen der Thermoden bei Automaten wegen hoher Ausschussraten unwirtschaftlich. Diesen Zustand vermögen auch bewegliche Thermoden mit starren Elektrodenflächen nicht zu beheben.

Die Praxis zeigt, dass derartige Lötvorgänge vielfach unter erschwerten Bedingungen durchzuführen sind, dann nämlich, wenn:

- die Leiterplatten verbogen sind,
- der Bauteil ungleichmässige Anschlussdicken aufweist,
- die Lötmengen auf den Leiterplatten ungleichmässig verteilt sind,
- die Dicke der Substrate nicht gleichmässig ist,
- die zu lötenden Oberflächen Schmutzpartikel aufweisen,
- unebene Thermodenlötflächen vorliegen,

- der Lötkopf bezüglich des zu lötenden Bauteils schief steht.

Die erfindungsgemässe Thermode, welche den zu lötenden Oberflächenkonfigurationen durch elastische Verformung Rechnung trägt, bringt ferner den Vorteil mit sich, dass:

- keine Spannvorrichtungen mehr nötig sind, um nicht ebene Leiterplatten vor dem Löten eben zu spannen,
- die Thermoden mit weniger hoher Präzision, d.h. billiger hergestellt werden können,
- Stützmassen verschiedener Dicke eine Anpassung an das zu lötende Material und dessen Form erlauben,
- die Maschinenmassgenauigkeiten auf die Qualität der Lötung einen geringeren Einfluss ausüben,
- der ganze Lötvorgang sicherer und billiger bei grossen Stückzahlen möglich ist,
- mit kleineren thermischen, zu erhitzten Massen gearbeitet werden kann und somit kürzere Lötzeiten erreicht werden,
- für die Herstellung der Thermoden billigere Standardmaterialien verwendbar sind, da sie keine spezifische Temperatureigenschaften haben müssen.

Die Stützmasse ist so zu wählen, dass sie den normalerweise auftretenden Temperaturen im Bereiche von 400 bis 500° C standhalten kann.

Alle in der Beschreibung und/oder den Figuren dargestellten Einzelteile und Einzelmerkmale sowie deren Permutationen, Kombinationen und Variationen sind erfinderisch, und zwar für n Einzelteile und Einzelmerkmale mit den Werten n = 1 bis n→∞.

**Patentansprüche**

1. Thermode (7) für einen elektrisch beheizten Lötkopf einer Lötmaschine, insbesondere eines Lötautomaten, gekennzeichnet durch einen Träger (8) und ein zum Aufliegen auf dem Lötgut vorgesehenes Heizorgan (11), welches federelastisch ausgebildet ist, um sich der Form und Lage der Lötstellen anzupassen.

2. Thermode, vorzugsweise nach mindestens einen der Ansprüche, dadurch gekennzeichnet, dass das Organ (11) draht- oder streifenförmig ausgebildet ist.

3. Thermode, vorzugsweise nach mindestens einem der Ansprüche, dadurch gekennzeichnet, dass das Organ (11) schraubenförmig gewunden ist.

4. Thermode, vorzugsweise nach mindestens einem der Ansprüche, dadurch gekennzeichnet, dass das Organ (11) über Zugfedern mit den Polen (12) der Thermode (7) verbunden ist.

5. Thermode, vorzugsweise nach mindestens einem der Ansprüche, dadurch gekennzeichnet, dass zwischen dem Träger (8) und dem Organ (11) eine gummielastische Stützmasse (9) angeordnet ist.

6. Thermode, vorzugsweise nach mindestens einem der Ansprüche, dadurch gekennzeichnet, dass das Heizorgan (11) in der Stützmasse (9) geführt ist, z.B. in einer Nut (18).

7. Thermode, vorzugsweise nach mindestens einem der Ansprüche, dadurch gekennzeichnet, dass die Stützmasse (9) formschlüssig, z.B. mittels einer Schwalbenschwanzführung (13), oder kraftschlüssig, z.B. durch Klebung (16), mit dem Träger (8) verbunden ist.

8. Thermode, vorzugsweise nach mindestens einem der Ansprüche, dadurch gekennzeichnet, dass das Organ (11) eine mechanische Vorspannung aufweist.

9. Thermode, vorzugsweise nach mindestens einem der Ansprüche, dadurch gekennzeichnet, dass das Organ (11) selbst elastisch ist.

Fig. 1

Fig. 2

Fig. 3

Fig. 4

Fig. 5